Europäisches Patentamt

European Patent Office

Office européen des brevets

(11) Publication number: **0 395 213**
**A2**

# EUROPEAN PATENT APPLICATION

(21) Application number: **90302834.8**

(22) Date of filing: **16.03.90**

(51) Int. Cl.5: **G11C 8/00**

(30) Priority: **26.04.89 US 343335**

(43) Date of publication of application:
**31.10.90 Bulletin 90/44**

(84) Designated Contracting States:
**AT BE CH DE DK ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Tran, Thang M.**
**4821 Riverside No. 117**
**Austin, Texas 78741(US)**

(74) Representative: **Wright, Hugh Ronald et al**
**Brookes & Martin 52/54 High Holborn**
**London WC1V 6SE(GB)**

(54) **Decoder.**

(57) A clocked decoder circuit for a random access memory is disclosed wherein the rise and fall time delays of the output of the decoder circuit are minimized to permit the reading of data as soon as the precharge of the RAM is completed and to avoid conflict situations which result when a word line of the RAM is selected at the same time as the precharge operation is taking place.

EP 0 395 213 A2

# DECODER

The present invention is directed to decoder circuits. More specifically, we will describe a clocked decoder circuit having an improved propagation delay time.

In two-phase clock random access memory (RAM) arrays, the word lines of the memory cells are selectively driven by the outputs of a clocked decoder circuit. The RAM array precharges on phase-one of the clock (PH1) and the outputs of the decoder circuit must be activated on phase-two of the clock (PH2) to select the word lines of a RAM array. In other words, the outputs of the decoder circuit need to be at a low circuit logic level (LO) when PH1 is at a high circuit logic level (HI) and the precharge is taking place, and one output of the decoder circuit must be HI when PH2 is HI to select a word line of the RAM array.

Conventional decoder circuits may consist, for example, of a number of output branch circuits, each branch circuit including a multiple input NAND gate coupled to an inverter in which one of the inputs to the NAND gate is PH2. Ideally, it would be desirable to select a word line of the RAM array as soon as the precharge is turned off, i.e., upon the transition of PH1 from HI to LO and of PH2 from LO to HI, in order to immediately read data from the RAM array. The output signal of the decoder circuit which selects the word line, however, has an associated rise time delay and fall time delay with respect to the clock transitions due to signal propagation delays through the NAND gate and inverter. The rise time delay prevents immediate selection of the word line, thereby slowing access time to the memory array. The fall time delay is also undesirable because the word line would remain selected after PH1 has switched HI to begin the precharge resulting in a conflict situation.

We will describe a decoder circuit wherein the rise and fall time delays are minimized to permit the reading of data as soon as the precharge is completed and to avoid the conflict situation described above.

More specifically, in a preferred embodiment of the invention, the decoder circuit includes a multi-input NAND gate having an output that is connected to an inverter via a N-type coupling transistor. A P-type pull up transistor is also connected to the input of the inverter. The operation of both the N-type coupling transistor and the P-type pull up transistor is controlled by PH2. The fall time delay is minimized when PH2 goes LO by turning the N-type coupling transistor off and turning the P-type transistor on to directly drive the input of the inverter HI, thereby avoiding the propagation delay time associated with the NAND gate.

A further embodiment of the invention is based on the recognition that PH2 is the only critical input to the NAND gate when it is desired to drive the output of the decoder circuit LO. Thus, the structure of the NAND gate can be modified to incorporate the pull up transistor described above directly at the PH2 input to drive the output of the NAND gate HI without regard to the other inputs. Accordingly, the overall ratios of the P-type and N-type transistors employed in the NAND gate structure can be proportioned in a manner to improve the rise time delay of the decoder circuit.

## Brief Description of the Drawings

With the above as background, reference should now be made to the following detailed description of the preferred embodiments of the invention and the figures in which:

Figs. 1A-1C respectively illustrate one branch circuit of a conventional clocked decoder, one branch circuit of a clocked decoder in accordance with a first embodiment of the invention, and one branch circuit of a clocked decoder in accordance with a second embodiment of the invention;

Fig. 2 is a graph illustrating a simulation of the output signals generated by each circuits illustrated in Figs. 1A-1C;

Figs. 3A-3C illustrate branch circuits for use in seven input clocked decoders that incorporate NAND gates in their first stage;

Fig. 4 is a graph illustrating a simulation of the output signals generated by the circuits shown in Figs. 3A and 3B;

Fig. 5 illustrates the structure of a NAND gate;

Fig. 6 is a graph illustration a simulation of the output signals generated by the circuits illustrated in Figs. 3A and 3C;

Figs. 7A-7B illustrate branch circuits for use in seven input clocked decoders that incorporate NOR gates in their first stages;

Fig. 8 is a graph comparing the output signals from the circuits illustrated in Figs. 7A and 7B; and

Fig. 9 illustrates a four-to-sixteen line decoder the utilizes the circuit illustrated in Fig. 1B.

## Detailed Description of the Preferred Embodiments

Referring now to Fig. 1A, one branch of a conventional clocked decoder circuit 10 is shown having a multiple input NAND gate 12 coupled to an inverter 14, wherein one of the inputs to the NAND gate is the clock signal PH2. As described above, the output line (OUT1) of the decoder circuit is used to select a word line of a two-phase clock RAM (not shown) when PH2 is HI. The RAM precharges when PH1 is HI (PH1 being the inverse of PH2) and it is desirable to select a word line of the RAM by driving OUT1 HI as soon as the precharge is turned off, i.e., upon the transition of PH1 from HI to LO and of PH2 from LO to HI, in order to immediately read data from the RAM. It is equally important to deselect the word line as soon as possible by driving OUT1 LO as soon as the precharge is turned on, i.e., upon the transition of PH1 from LO to HI and PH2 from HI to LO, to prevent the word line from remaining selected while the precharge is starting.

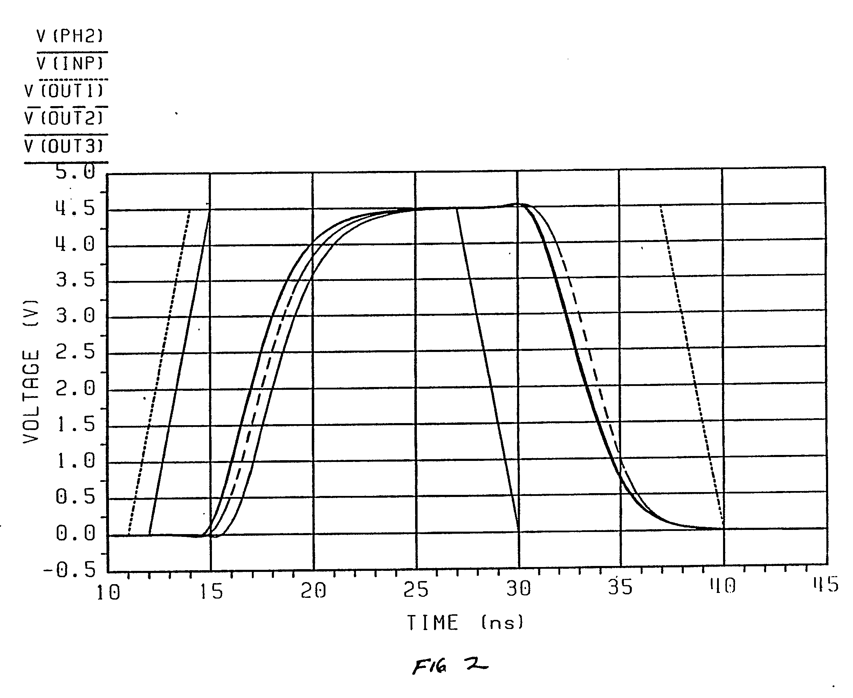

The output signal of the decoder circuit 10 which selects the word line, however, has an associated rise time delay and fall time delay with respect to the transition of PH2 as the signal must propagate through the NAND gate 12 and the inverter 14. The magnitude of the rise and fall time delays is shown in Fig. 2, which illustrates OUT1 in response to PH2 and an input signal (INP).

A first embodiment of a decoder circuit 16 according to the present invention is shown in Fig. 1B. The decoder circuit 16 also incorporates a multiple input NAND gate 18 and an inverter 20, however, an N-type coupling transistor 22 is also provided to selectively couple the output signal from the NAND gate 18 to the inverter 20 when turned on, and a P-type pull up transistor 24 is provided to selectively pull the input of the inverter 20 HI when turned on. The gates of the coupling transistor 22 and the pull up transistor 24 are controlled by PH2.

In operation, the coupling transistor 22 is turned on when PH2 goes HI thereby allowing the output of the NAND gate 18 to pass to the input of the inverter 20. The coupling transistor 22 is turned off and the pull up transistor 24 is turned on to pull the input of the inverter 20 HI when PH2 changes from HI to LO. The fall time delay of the output signal (OUT2) of the decoder circuit 16 is less than the fall time delay of OUT1 of the decoder circuit 10, as any propagation delay attributable to the NAND gate 18 is avoided by directly pulling the input of the inverter 20 HI with the pull up transistor 24.

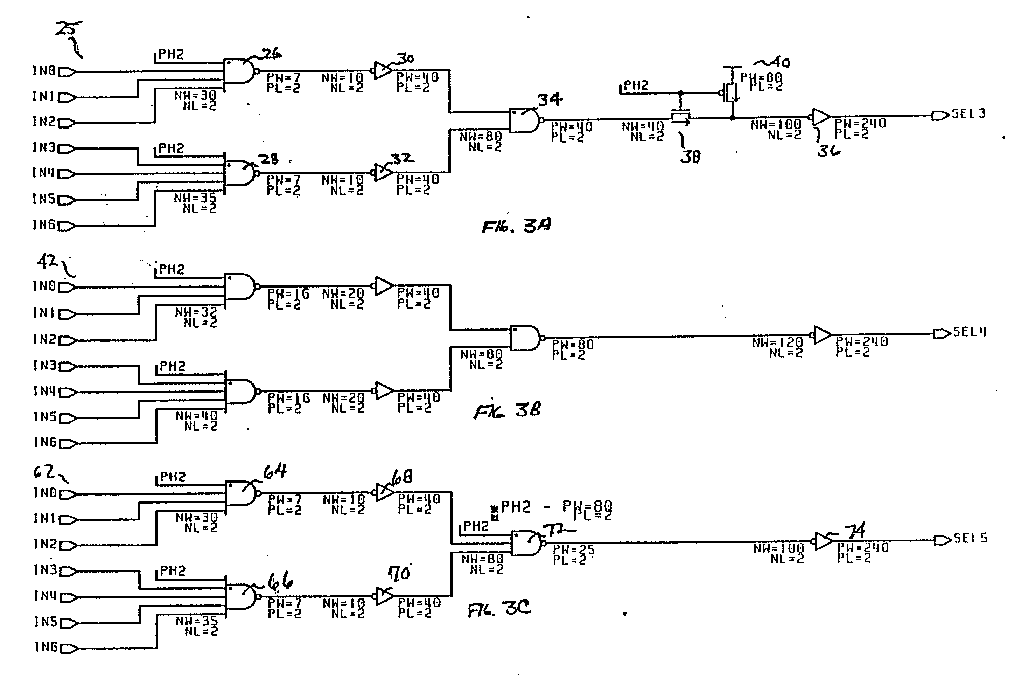

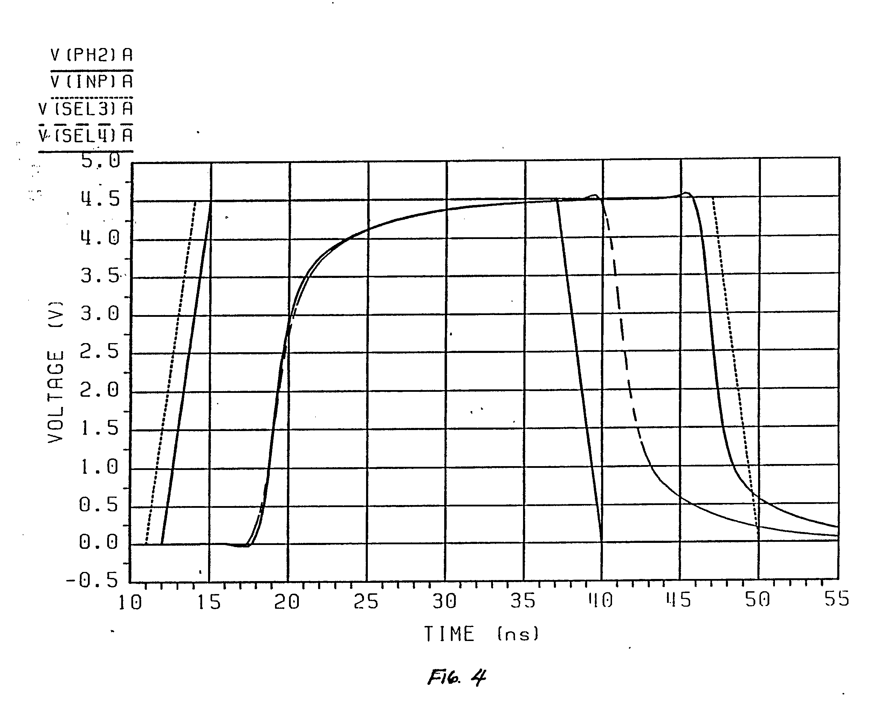

The improvement in the fall time delay is shown in the graph of Fig. 2. It should be noted that the decoder circuits 12 and 16 are four input decoders and the improvement noted in the fall time delay is relatively small when compared with higher order decoders which require additional logic stages. For example, Fig. 3A illustrates a seven input decoder circuit 25 having a first stage of NAND gates 26 and 28 coupled to inverters 30 and 32. The output of the inverters 30 and 32 is coupled to a second stage NAND gate 34. The output of the NAND gate 34 is selectively coupled to an inverter 36 via a coupling transistor 38, and a pull up transistor 40 is also connected to the input of the inverter 36. Fig. 3B illustrates a conventional seven input decoder circuit 42. As shown in Fig. 4, the reduction in the fall time delay of the output signal (SEL3) from the decoder circuit 25 is significant compared with the fall time delay associated with the output signal (SEL4) of the decoder circuit 42.

While the decoder circuits 16 and 25 illustrated in Figs. 1B and 3A demonstrate an improved fall time delay and would be useful in applications where the fall time delay is critical, the rise time delay associated with these decoder circuits is either the same or slightly longer than the rise time delay associated with the conventional decoder circuits 10 and 42 illustrated in Fig. 1A and 3B. As described above, the rise time delay is also undesirable and should be minimized if possible.

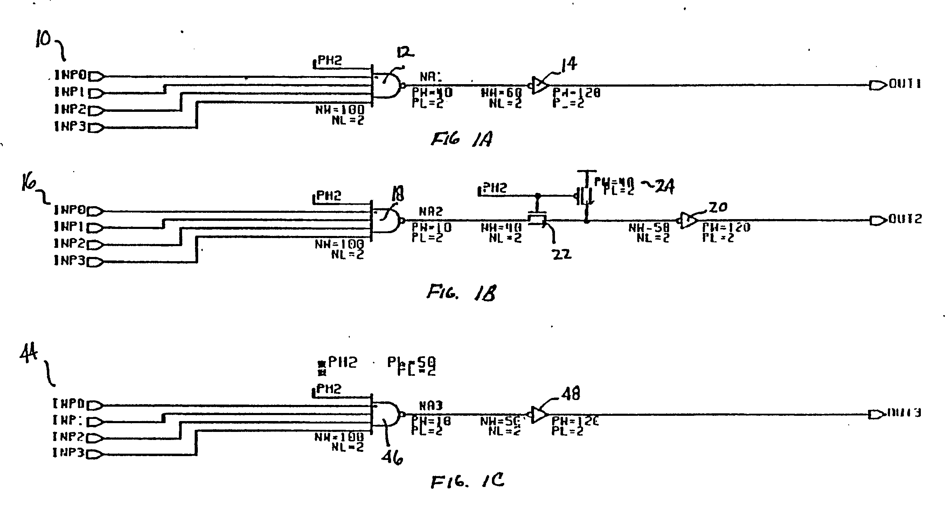

Referring now to Fig. 1C, one branch of a decoder circuit 44 according to a second embodiment of the invention is shown having a multiple input NAND gate 46 and an inverter 48. The distinction between the decoder circuit 44 and the decoder circuit 10, is that the P-type transistor employed for the PH2 input to the NAND gate 46 is sized differently than the other P-type input transistors. In contrast, the NAND gate 12 employed in the decoder circuit 10 illustrated in Fig. 1A is constructed so that the P-type and N-type transistors associated with each input to the NAND gate 12 are identical in size.

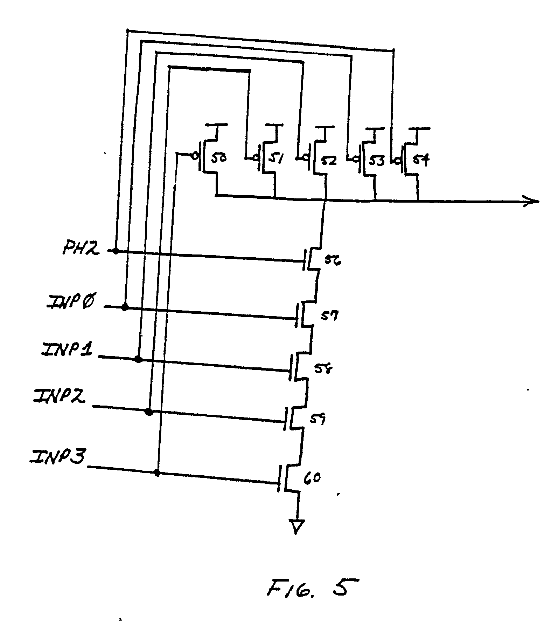

For example, a typical NAND gate structure is illustrated in Fig. 5, the NAND gate consists of P-type transistors 50-54 and N-type transistors 56-60 respectively coupled to the inputs of the NAND gate (PH2, IN0, IN1, IN2 and IN3). The NAND gate 12 employed in the decoder circuit 10 utilizes an equivalent P- channel width (PW) and length (PL) for each of the P-type transistors 50-54, and an equivalent N-channel width (NW) and length (NL) for each of the N-type transistors 56-60 as indicated in Figs. 1A. Providing transistors of equivalent size for each input to the NAND gate is done to balance the rise and fall time delays of the output of the NAND gate.

The clocked decoder circuit 44 illustrated in Fig. 1C, however, is based on the recognition that the only input to the NAND gate 46 of significance when the output of the decoder circuit (OUT3) must be driven LO is PH2. In other words, each of the other inputs which are indicative of the word line to be selected can be considered a logical DON'T CARE. The primary concern is to drive OUT3 LO as soon as possible after PH2 goes LO. Thus, the P-type transistor of the NAND gate 46 associated with the PH2 input (i.e. transistor 54 in Fig. 5) can be sized to pull the output signal of the NAND gate 46 HI as quickly as possible regardless of the state of the other inputs.

As indicated by the asterisk (*) in Fig. 1C, the P-type transistor associated with the PH2 input to the NAND gate 46 is made much larger than all other inputs to the NAND gate 46 (PW = 50 and PL = 2 for the PH2 input to NAND gate 46 while PW = 10 and PL = 2 for all other inputs), and is larger than the P-type transistor associated with the PH2 input to the NAND gate 12 in the decoder circuit 10 (PW = 40 and PL = 2 for all inputs). Thus, when PH2 goes HI the output of the NAND gate 46, which is connected directly to the inverter 48, is pulled high faster than in the NAND gate 12 of the decoder circuit 10 illustrated in Fig. 1A, thereby resulting in a faster fall time delay for the decoder circuit 44. In effect, the embodiment illustrated in Fig. 1C incorporates the pull up transistor 24 of the embodiment illustrated in Fig. 1B as part of the structure of the PH2 input to the NAND gate 46 and has a nearly identical fall time delay as illustrated in Fig. 2.

Fig. 2 also indicates that the decoder circuit 44 also exhibits an improved rise time delay. The improvement results as the overall ratio of the size of the P-type transistors to the N-type transistors of the NAND gate 46 has been altered in comparison to NAND gate 12, to favor a faster HI-LO transition of the NAND gate 46 which results in a reduced rise time delay for OUT3.

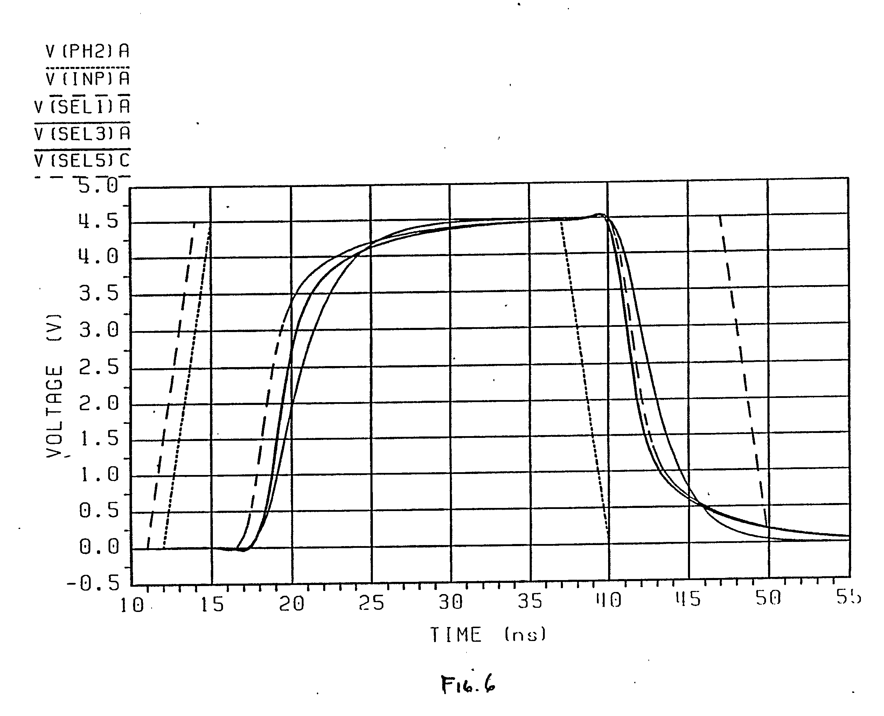

As with the decoder circuit illustrated in Fig. 1B, the improvement in the rise and fall time delays is more significant when a higher order decoder is employed. Fig. 3C illustrates a branch of a seven input clocked decoder having a first stage consisting of two conventional NAND gates 64 and 66 respectively coupled to two inverters 68 and 70. The output of the inverters 68 and 70 are supplied as inputs to a NAND gate 72 having a PH2 input that is modified in the same manner as the PH2 input to the NAND gate 46. The output of the decoder circuit 62 (SEL5) is compared in Fig. 6 to the output of the decoder circuit 25 (SEL3) illustrated in Fig. 3A in Fig. 6.

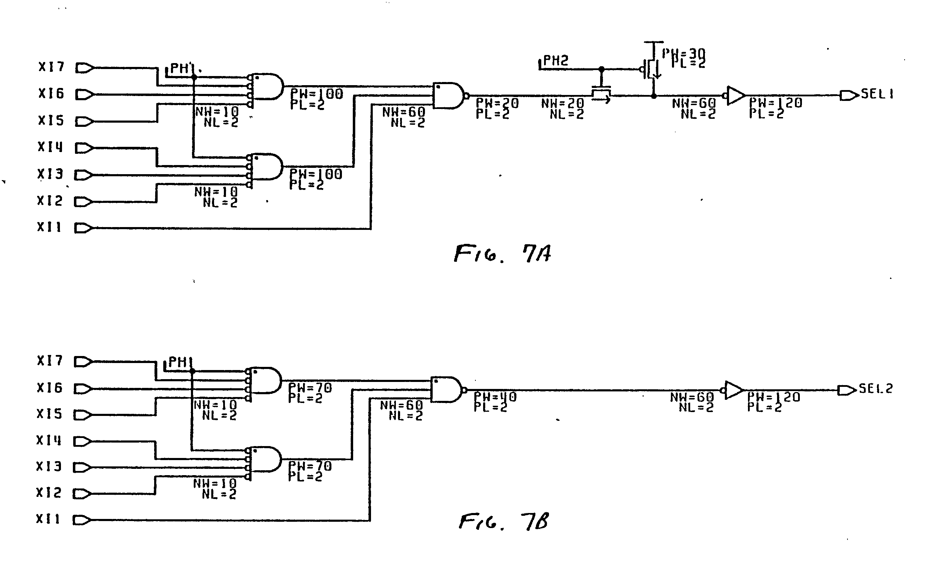

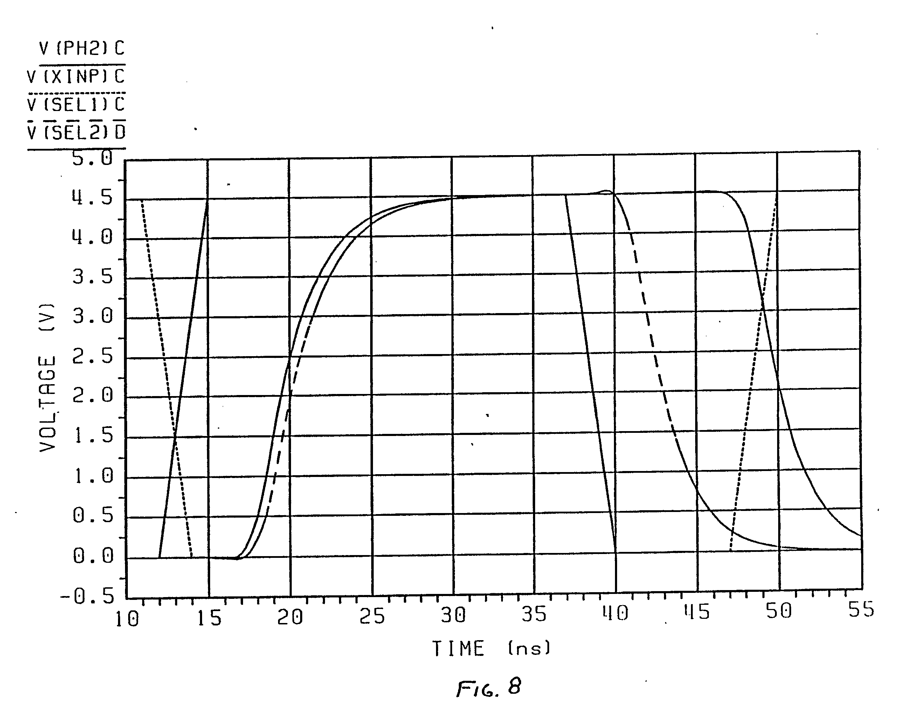

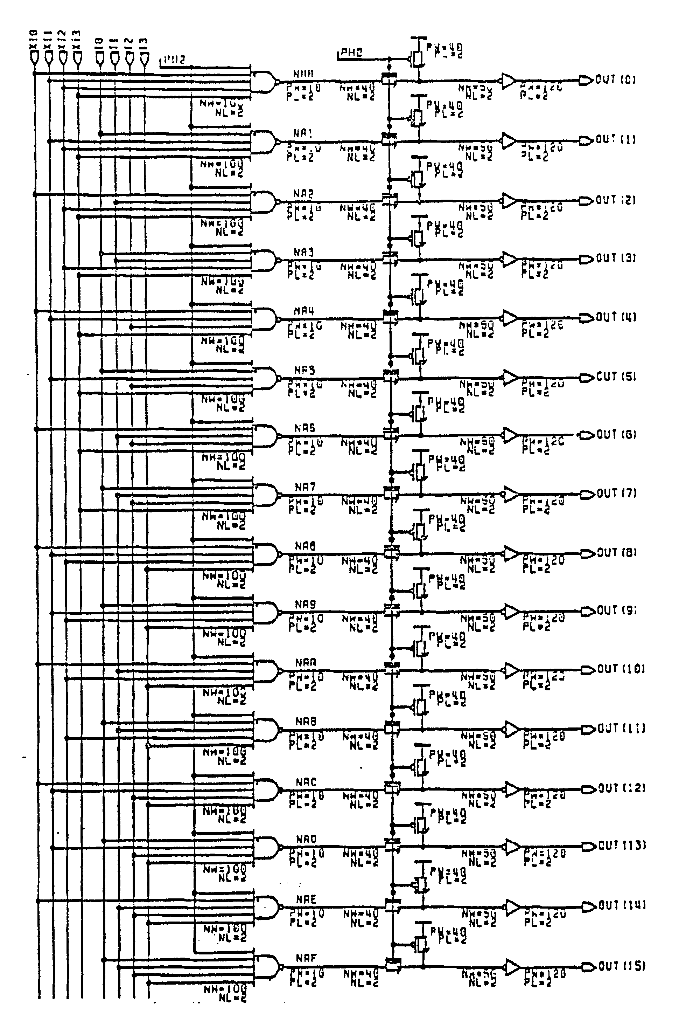

It will be understood that the above description is of preferred exemplary embodiments of the present invention, and the invention is not limited to the specific forms shown. For example, other logic configurations may be readily employed than those specifically set forth above. Fig. 7A illustrates a seven input decoder in accordance with the first embodiment of the invention described above that utilizes NOR gates in it's first logic stage. The outputs of the NOR gates are provided as inputs to a NAND gate whose outputs are selectively coupled to an inverter via a N-type coupling transistor. The inverter input is also connected to a P-type pull up transistor. A conventional decoder circuit that does not utilize the coupling transistor and the pull up transistor is illustrated in Fig. 7B. Fig. 8 is a simulation of the output responses of the decoder circuits illustrated in Figs. 7A and 7B. Further, it would be readily apparent to one of ordinary skill in the art how multiple branch decoder circuits of the types illustrated in Figs. 1B, 1C, 3A and 3B would be connected to form a full decoder. For example, Fig. 9 illustrates a four-to-sixteen line decoder that utilized the circuit illustrated in Fig. 1B. Additional variations and modifications can be effected within the spirit and scope of the invention as expressed in the appended claims.

## Claims

1. A decoder including at least one branch circuit, said branch circuit comprising a multiple input logic gate, said multiple input logic gate having an output that is selectively coupled to an input of an inverter with a coupling transistor, said input of said inverter also being connected to a pull up transistor, wherein said coupling transistor and said pull up transistor are complementary in operation and are controlled by a common control signal.

2. A decoder as claimed in claim 1, wherein said coupling transistor is an N-type transistor and said pull up transistor is a P-type transistor and the gates of said coupling transistor and said pull up transistor are coupled together and are controlled by said control signal.

3. A decoder as claimed in claim 2, wherein said multiple input logic gate is a NAND gate and said control signal is supplied as an input to said NAND gate.

4. A decoder as claimed in claim 2, further comprising at least two first stage multiple input logic gates having outputs that are coupled to the inputs of said multiple input logic gate.

5. A decoder as claimed in claim 4, wherein said first stage multiple input logic gates and said multiple input logic gate are NAND gates, and said control signal is supplied as an input to said first stage multiple input logic gates.

6. A decoder including at least one branch circuit, said branch circuit comprising a logic gate having at least one control input, a plurality of data inputs and an output that is coupled to an inverter, said logic gate including a complementary pair of transistors corresponding to each of said control input and said data inputs, wherein said complementary pair of transistors corresponding to said control input cause said output of said logic gate to change state in response to a first phase of a two phase control signal regardless of state of said data inputs.

7. A decoder as claimed in claim 6, wherein said complementary pairs of transistors comprise P-type transistors and N-type transistors, said P-type transistors being arranged in parallel with their drains connected to a positive voltage potential and their sources connected to said output, said N-type transistors being arranged in series to connect said output to electrical ground when said N-type transistors are turned ON, and the gates of said N-type and P-type transistors being connected to their corresponding control input or data input.

8. A decoder circuit as claimed in claim 6, wherein said multiple input logic gate is a NAND gate.

9. A decoder as claimed in claim 6, further comprising at least two first stage multiple input logic gates having outputs that are coupled to the inputs of said multiple input logic gate.

10. A decoder as claimed in claim 9, wherein said first stage multiple input logic gates and said multiple input logic gate are NAND gates, and said control signal is supplied as an input to said NAND gates.

EP 0 395 213 A2

10

INP0
INP1
INP2
INP3

PH2

12

NA:
PH=10
PL=2
NH=100
NL=2

NH=60
NL=2

14

PH=120
PL=2

OUT1

*FIG 1A*

16

INP0
INP1
INP2
INP3

PH2

18

NA2
PH=10
PL=2
NH=100
NL=2

PH2

NH=40
NL=2

22

PH=40
PL=2

24

NH=50
NL=2

20

PH=120
PL=2

OUT2

*FIG. 1B*

44

PH2
PH=50
PL=2

PH2

INP0
INP1
INP2
INP3

NA3
PH=10
PL=2
NH=100
NL=2

46

NH=50
NL=2

48

PH=120
PL=2

OUT3

*FIG. 1C*

FIG 2

FI6. 3A

FIG. 3B

FIG. 3C

Fig. 4

FIG. 5

V (PH2) A
V (INP) A
V (SEL1) A
V (SEL3) A
V (SEL5) C

Fig. 6

EP 0 395 213 A2

X17

X16

X15

X14

X13

X12

X11

PH1

NH=10
NL=2

PW=100
PL=2

NH=10
NL=2

PW=100
PL=2

NH=60
NL=2

PW=20
PL=2

PH2

NH=20
NL=2

PW=30
PL=2

NH=60
NL=2

PW=120
PL=2

SEL1

*FIG. 7A*

X17

X16

X15

X14

X13

X12

X11

PH1

NH=10
NL=2

PW=70
PL=2

NH=10
NL=2

PW=70
PL=2

NH=60
NL=2

PW=40
PL=2

NH=60
NL=2

PW=120
PL=2

SEL2

*FIG. 7B*

EP 0 395 213 A2

FIG. 8

EP 0 395 213 A2